# DEMANDE DE BREVET EUROPEEN

(11) **EP 4 160 694 A1**
(43) Date de publication de la demande: **05.04.2023**
(21) Numéro de dépôt: 22198944.5
(22) Date de dépôt: 30.09.2022
(51) Int. Cl.: H01L 29/06, H01L 27/10, H01L 29/423, H01L 29/66, B82Y 10/00

(54) **PROCÉDÉ DE FABRICATION D'UN CIRCUIT ÉLECTRONIQUE QUANTIQUE**

(30) Priorité: 01.10.2021 FR 2110390
(71) Demandeur: Commissariat à l'énergie atomique et aux énergies alternatives, 75015 Paris (FR)
(72) Inventeur: NIEBOJEWSKI, Heimanu, 38054 GRENOBLE CEDEX 09 (FR); BEDECARRATS, Thomas, 38054 GRENOBLE CEDEX 09 (FR); BERTRAND, Benoit, 38054 GRENOBLE CEDEX 09 (FR)
(74) Mandataire: Cabinet Camus Lebkiri

(57) **Abrégé**

L'invention concerne un procédé de fabrication d' un circuit électronique quantique comprenant une couche semi-conductrice destinée à recevoir des qubits dans des îlots quantiques. La couche qubits peut recevoir les qubits pendant leur stockage et leur manipulation.Un aspect de l'invention concerne un procédé de fabrication d'un circuit (DISP) électronique quantique comprenant les étapes suivantes :
- graver une couche semiconductrice de manière à obtenir :
- une pluralité de piliers (PLR) chaque pilier semi-conducteur présentant une première extrémité, dite "base"; et
- une couche qubits (QBL) à la base de chaque pilier semiconducteur ;;

- oxyder le flanc de chaque pilier (PLR) ;
- former des lignes de couplage (CL) et des colonnes de couplage (CC) ; et
- déposer des couches de séparation (SEP1, SEP2, SEP3) en laissant dépasser une surface de contact (CS) de chaque pilier (PLR).

## Description

### DOMAINE TECHNIQUE DE L'INVENTION

Le domaine technique de l'invention est celui de l'électronique quantique et plus particulièrement la fabrication d'un circuit électronique quantique.

### ARRIÈRE-PLAN TECHNOLOGIQUE DE L'INVENTION

La manipulation d'états quantiques, également appelés "qubits" pour "quantum bits" en anglais, offre de nouvelles possibilités dans la manipulation d'information. Les circuits électroniques quantiques à même de permettre la manipulation de qubits, comprennent des îlots, également appelés boîtes quantiques. Les boîtes quantiques sont capables stocker des qubits le temps de leur manipulation et de leur mesure.

L'intégration de boîtes quantiques sous forme de circuits électroniques quantiques doit satisfaire plusieurs exigences. D'une part offrir une haute densité de boîtes quantiques afin d'offrir une capacité calculatoire conséquente. D'autre part, les procédés de fabrication desdits circuits électroniques quantiques doivent permettre d'atteindre une cadence de production industrielle tout en assurant une faible variabilité des circuits. En effet, le stockage et la manipulation des qubits au sein de boîtes quantiques sont fortement tributaires des couplages entre les différents composants formant les circuits électroniques quantiques.

Les circuits électroniques quantiques doivent offrir la possibilité de coupler plusieurs qubits entre eux pour permettre d'effectuer un calcul à partir d'un ensemble de qubits. Dans certains cas, l'opération de couplage s'effectue en contrôlant un couplage tunnel entre des boites quantiques contenant les qubits. En revanche, le contrôle des couplages tunnels impose une architecture des boites quantiques interconnectées sous forme de matrices denses. De plus, les boîtes quantiques doivent également pouvoir être couplées à des réservoirs de porteurs de charge et des détecteurs de charge. Afin de permettre la densification des boîtes quantiques, il est proposé d'intégrer et connecter les réservoirs de porteurs de charges et les détecteurs de charges dans des plans différents du plan comprenant les boîtes quantiques. On parle dans ce cas de circuits à architecture non-planaire, dite également "3D" pour "à 3 dimensions".

Deux types de circuits à architecture 3D émergent aujourd'hui. Les circuits dits à contrôle individuel des qubits d'une part, également appelé "fully controlled" en anglais, et les circuits dits à contrôle parallèle des qubits d'autre part, également appelé "crossbar network". Si les circuits à contrôle individuel facilitent la manipulation des qubits, ils présentent en revanche une architecture électrique complexe, avec une forte densité de vias et d'interconnexions. Les circuits à contrôle parallèle offrent quant à eux une architecture plus simple, notamment grâce à la réduction de la densité de vias et d'interconnexions.

La demande de brevet FR 3 066 297 propose une méthode de fabrication d'un circuit électronique quantique à contrôle parallèle. Le procédé de fabrication comprend dans un premier temps la formation de boîtes quantiques dans une couche semiconductrice. Le procédé comprend ensuite la formation de réseaux d'électrodes superposés les uns sur les autres et enrobés dans une épaisse couche de matériau diélectrique.

Le procédé divulgué comprend également la formation de piliers traversant de part et d'autre ladite couche de matériau diélectrique et les réseaux d'électrodes jusqu'à atteindre les boîtes quantiques. L'étape de formation des piliers comprend une gravure de la couche diélectrique et des réseaux d'électrodes enrobés de manière à former des cavités évidées atteignant la surface des boîtes quantiques. Une reprise de contact au niveau des boîtes quantiques est réalisée par épitaxie d'un matériau semiconducteur dans les cavités évidées. L'étape de formation des piliers comprend également, avant la reprise de contact, la formation d'une couche d'oxyde sur les parois latérales des cavités évidées afin d'isoler les piliers des réseaux d'électrodes enrobés. Les piliers semiconducteurs ainsi formés, en contact avec les boîtes quantiques, permettent l'initialisation des qubits ainsi que leur mesure.

En revanche, ce procédé pose quelques problèmes. Dans un premier temps, la formation des boîtes quantiques à lieu en face avant d'un substrat de silicium sur isolant (SOI en anglais) tandis que la formation des réseaux d'électrodes et la reprise de contact des piliers sont réalisées en face arrière dudit substrat. Le procédé impose donc une étape de collage et de retournement du substrat et une libération de la face arrière des boîtes quantiques. Les étapes de collage/retournement peuvent être difficiles à réaliser et peuvent occasionner des défauts au niveau de l'interface de collage, tels qu'un désordre électrostatique. De plus, les variations d'alignements des piliers par rapport aux boîtes quantiques peuvent modifier le couplage entre lesdits piliers et boîtes quantiques.

Dans un second temps, la formation de la couche d'oxyde dans les cavités évidés est dans un premier temps réalisée au niveau des bords latéraux et du fond de la cavité. Le fond de la cavité est ensuite libéré par gravure anisotrope pour mettre à nu la surface des boîtes quantiques et permettre l'épitaxie des piliers à partir des boîtes quantiques. Le dépôt d'oxyde suivie d'une gravure anisotrope peut rendre l'interface entre les boîtes quantiques et le pilier défectueuse.

Le procédé divulgué ne permet donc pas de réduire la variabilité des circuits produits.

### RÉSUME DE L'INVENTION

L'invention offre une solution au problème évoqué, en permettant de réaliser un circuit électronique quantique sans interface entre les piliers semiconducteurs et une couche semiconductrice destinée à recevoir les boîtes quantiques.

Pour cela, l'invention concerne un procédé de fabrication d'un circuit électronique quantique, le procédé étant mis en œuvre à partir d'un substrat comportant sur l'une de ses surfaces une première couche semiconductrice monocristalline et comprenant les étapes suivantes :
- graver la première couche semiconductrice de manière à :
   - obtenir une pluralité de piliers semiconducteurs, chaque pilier semiconducteur présentant une première extrémité, dite "base" ; et
   - conserver une partie de la première couche semiconductrice dite "couche qubits", à la base de chaque pilier semiconducteur ;
- oxyder le flanc de chaque pilier semiconducteur de manière à former une pluralité de premières couches diélectriques, dites "diélectriques de flanc" ;
- déposer une deuxième couche diélectrique, dite "première couche de séparation", sur la couche qubits ;
- former une pluralité de premières électrodes conductrices sensiblement parallèles entre elles, dites "lignes de couplage", sur la première couche de séparation, chaque ligne de couplage étant en contact avec le diélectrique de flanc d'au moins un pilier semiconducteur ;
- déposer une troisième couche diélectrique, dite "deuxième couche de séparation", sur la pluralité de lignes de couplage ;
- former une pluralité de deuxièmes électrodes conductrices sensiblement parallèles entre elles, dites "colonnes de couplage", sur la deuxième couche de séparation, chaque colonne de couplage étant en contact avec le diélectrique de flanc d'au moins un pilier semiconducteur ;
- déposer une quatrième couche diélectrique, dite "troisième couche de séparation", sur la pluralité de colonnes de sorte qu'une portion de chaque diélectrique de flanc dépasse de la troisième couche de séparation ; et
- graver chaque portion des diélectriques de flanc dépassant de la troisième couche de séparation afin d'exposer une surface de chaque pilier semiconducteur, dite "surface de contact".

Le procédé permet ainsi de fabriquer un circuit électronique quantique comprenant une couche qubits dans laquelle peuvent être formés les boîtes quantiques destinées à recevoir les qubits. Le procédé permet de former des piliers semiconducteurs présentant une continuité cristalline avec la couche qubits. Ainsi, la variabilité des circuits produits est réduite.

Outre les caractéristiques qui viennent d'être évoquées dans le paragraphe précédent, le procédé selon l'invention peut présenter une ou plusieurs caractéristiques complémentaires parmi les suivantes, considérées individuellement ou selon toutes les combinaisons techniquement possibles :
- l'épaisseur de la couche qubits est comprise entre 5 nm et 35 nm ;
- les lignes de couplage croisent les colonnes de couplages préférentiellement selon un angle sensiblement droit ;
- la première couche semiconductrice est en silicium et de préférence enrichi par un isotope, par exemple le silicium 28 ;
- la première couche semiconductrice comprend une couche semiconductrice monocristalline en face avant et une couche semiconductrice monocristalline épitaxiée, la couche semiconductrice monocristalline épitaxiée étant obtenue au moyen d'une épitaxie pleine plaque à partir de la couche semiconductrice monocristalline en face avant.
- l'étape d'oxydation permettant de former le diélectrique de flanc pour chaque pilier semiconducteur comprend les sous-étapes suivantes : oxyder la surface libre de chaque pilier semiconducteur de sorte à former, au niveau du flanc de chaque pilier semiconducteur, une couche diélectrique sacrificielle ; retirer la couche diélectrique sacrificielle ; et oxyder la surface libre de chaque pilier semiconducteur de sorte à former, au niveau du flanc de chaque pilier semiconducteur, le diélectrique de flanc ;
- chaque diélectrique de flanc est obtenu par oxydation thermique du flanc de chaque pilier semiconducteur ;
- la formation de la pluralité de lignes de couplage comprend : déposer de manière conforme d'une première couche conductrice recouvrant intégralement la première couche de séparation et chaque pilier semiconducteur; déposer une cinquième couche de diélectrique de manière à recouvrir complètement la première couche conductrice ; graver la cinquième couche de diélectrique de manière à mettre à nu une pluralité de portions de la première couche conductrice, dites "capuchons", et conserver une épaisseur résiduelle de la cinquième couche de diélectrique, chaque capuchon recouvrant une portion supérieure de chaque pilier semiconducteur ; graver la première couche conductrice et la cinquième couche diélectrique de manière à retirer chaque capuchon et l'épaisseur résiduelle de la cinquième couche diélectrique ; et graver la première couche conductrice de manière à obtenir les lignes de couplage ;
- le procédé comprend, avant la gravure de la première couche semiconductrice, la formation d'une pluralité de plots de protection sur la première couche semiconductrice, la gravure de la première couche semiconductrice comprenant une gravure anisotrope d'une première partie de la première couche semiconductrice de manière à obtenir un pilier semiconducteur sous chaque plot sacrificiel ;
- le procédé comprend, après la gravure de chaque portion des diélectriques de flancs, les étapes supplémentaires suivantes : retirer le plot de protection de chaque pilier semiconducteur de manière à exposer la deuxième extrémité dudit pilier semiconducteur ; et déposer une couche conductrice dopée, dite "couche d'initialisation", recouvrant au moins la deuxième extrémité et la surface de contact de chaque pilier semiconducteur ;
- la couche d'initialisation est en silicium polycristallin fortement dopé ;
- le procédé comprend, après le dépôt de la couche d'initialisation, la formation de contacts conducteurs au niveau de chaque ligne de couplage, de chaque colonne de couplage et de la couche d'initialisation ;
- le procédé comprend, après la gravure de chaque portion des diélectriques de flancs, les étapes supplémentaires suivantes : former une pluralité de troisièmes électrodes conductrices dopées, dites "lignes de lecture", chaque ligne de lecture étant en contact avec au moins un pilier semiconducteur ; déposer une sixième couche diélectrique, dite "quatrième couche de séparation", recouvrant les lignes de lecture et recouvrant la pluralité de plots de protection ; aplanir la quatrième couche de séparation et la pluralité de lignes de lecture jusqu'à atteindre les plots de protection ; graver sélectivement la pluralité de plots de protection de manière à laisser une pluralité de cavités à l'aplomb de chaque pilier semiconducteur ; et former une structure de grille, "dite grille de chargement", dans chaque cavité ;
- chaque ligne de lecture est en contact avec la surface de contact d'au moins un pilier semiconducteur ;
- le procédé comprend, après la formation de chaque grille de chargement, la formation de contacts conducteurs au niveau de chaque ligne de couplage, de chaque colonne de couplage, de chaque ligne de lecture et de chaque grille de chargement.

Un autre aspect de l'invention concerne un circuit électronique quantique susceptible d'être obtenu par le procédé de fabrication selon l'invention.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention.

[FIG. 1] présente schématiquement un logigramme d'un procédé de fabrication selon un premier mode de mise en œuvre de l'invention.

[FIG. 2] présente schématiquement un substrat mis en œuvre par le procédé selon la [FIG. 1].

[FIG.3] à [FIG. 10b] présentent schématiquement les étapes du procédé selon la [FIG. 1].

[FIG. 11a] et [FIG. 11b] présentent schématiquement un premier mode de réalisation d'un circuit électronique quantique susceptible d'être obtenu par la mise en œuvre du procédé selon la [FIG. 1].

[FIG. 12] présente schématiquement un logigramme du procédé de fabrication selon un deuxième mode de mise en œuvre de l'invention.

[FIG. 13] et [FIG. 14] présentent schématiquement les étapes du procédé selon la [FIG. 12].

[FIG. 15] présente schématiquement un deuxième mode de réalisation du circuit électronique quantique susceptible d'être obtenu par la mise en œuvre du procédé selon la [FIG. 12].

[FIG. 16] présente schématiquement un logigramme du procédé de fabrication selon un troisième mode de mise en œuvre de l'invention.

[FIG. 17a] à [FIG. 23b] présentent schématiquement les étapes du procédé selon la [FIG. 16].

[FIG. 24] présente schématiquement un troisième mode de réalisation du circuit électronique quantique susceptible d'être obtenu par la mise en œuvre du procédé selon la [FIG. 16].

[FIG. 25] présente schématiquement un développement du circuit électronique quantique selon la [FIG. 24].

Sauf précision contraire, un même élément apparaissant sur des figures différentes présente une référence unique.

Les figures sont présentées à titre indicatif et nullement limitatif de l'invention.

### DESCRIPTION DÉTAILLÉE

L'invention se propose de réduire la variabilité du comportement électronique d'un circuit électronique quantique obtenue lors de sa fabrication. La réduction de variabilité est notamment obtenue par l'amélioration de l'interface entre une couche semiconductrice, destinée à recevoir des bits quantiques également appelé "qubits", et des piliers semiconducteurs, destiné à initialiser et mesurer lesdits qubits.

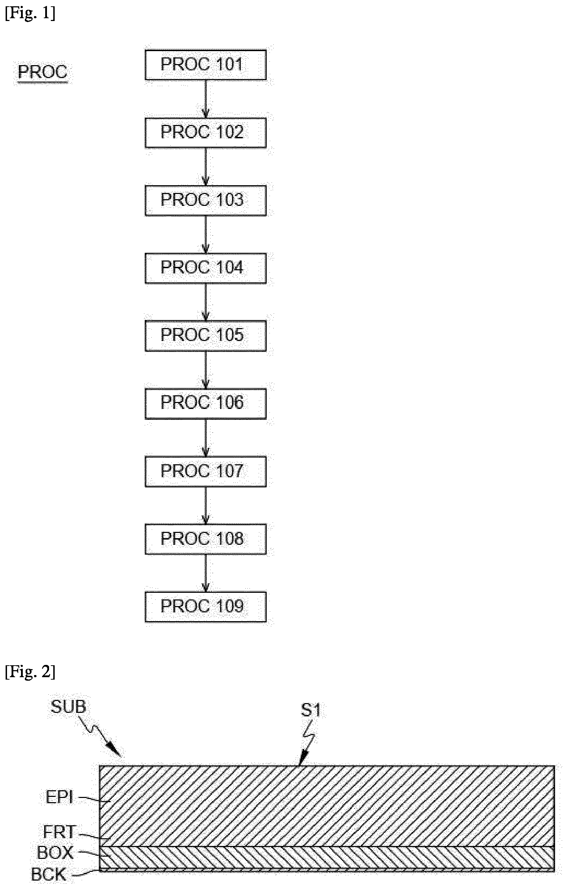

La [FIG. 1] présente schématiquement un premier mode de mise en œuvre d'un procédé PROC de fabrication selon l'invention, permettant d'obtenir un circuit DISP électronique quantique selon un premier mode de réalisation. Le procédé PROC comprend les étapes suivantes :
- graver PROC102 une première partie de ladite première couche semiconductrice de manière à obtenir :
   - une pluralité de piliers semiconducteurs ; et
   - conserver une deuxième partie de la première couche semiconductrice, dite "couche qubits" ;
- oxyder PROC103 le flanc de chaque pilier semiconducteur de manière à former une pluralité de premières couches diélectriques, dites "diélectriques de flanc" ;
- déposer PROC104 une deuxième couche diélectrique, dite "première couche de séparation", sur la couche qubits ;
- former PROC105 une pluralité de premières électrodes conductrices, dites "lignes de couplage", sur la première couche de séparation ;
- déposer PROC106 une troisième couche diélectrique, dite "deuxième couche de séparation", sur la pluralité de lignes de couplage ;
- former PROC107 une pluralité de deuxièmes électrodes conductrices, dites "colonnes de couplage", sur la deuxième couche de séparation ;
- déposer PROC108 une quatrième couche diélectrique, dite "troisième couche de séparation", sur la pluralité de colonnes de sorte qu'une portion de chaque diélectrique de flanc dépasse de la troisième couche de séparation ; et
- graver PROC109 chaque portion du diélectrique de flancs dépassant de ladite troisième couche de séparation de manière à obtenir une surface de chaque pilier semiconducteur exposée, dite "surface de contact".

Le procédé PROC permet ainsi de fabriquer un circuit électronique quantique comprenant une couche qubits. La couche qubits peut recevoir les qubits pendant leur stockage et leur manipulation.

Le procédé proposé par le document de l'art antérieur FR 3 066 297 comprend une reprise de contact par épitaxie au niveau des boîtes quantiques. Toutefois, une croissance par épitaxie peut provoquer un réajustement cristallin et/ou l'apparition de défaut à l'interface entre la couche de démarrage et la couche épitaxiée. Le procédé selon l'invention permet d'obtenir la couche qubits et les piliers semiconducteurs gravés dans la même première couche semiconductrice, c'est à dire dans le même cristal. Ladite gravure permet de délimiter la pluralité de piliers semiconducteurs et la couche qubits tout en conservant une continuité cristalline entre la couche et les piliers, évitant ainsi l'apparition de défauts ou d'une interface. La continuité cristalline peut être contrôlée par des techniques d'imagerie telles que la microscopie électronique à balayage ou la microscopie électronique à transmission. Un dispositif obtenu par l'invention montrerait une absence d'interface entre la couche qubits et les piliers semiconducteurs. Un dispositif obtenu par un procédé de l'art antérieur montrerait des défauts ou une interface entre la couche qubits et les piliers semiconducteurs.

Le procédé selon l'invention permet également de simplifier la fabrication des circuits en réduisant le nombre de reports nécessaire pour fabriquer les lignes et colonnes de couplage et la couche qubits.

La gravure PROC102 de la pluralité de piliers semiconducteur PLR peut être réalisée à partir d'un substrat SUB tel qu'illustré par la [FIG. 2], comportant sur l'une de ces surfaces la première couche semiconductrice S1. La première couche semiconductrice S1 est monocristalline et comprend avantageusement une densité de défauts inférieure à 10⁶ cm⁻³. La première couche semiconductrice S1 présente une épaisseur, mesurée perpendiculairement à la surface libre, préférentiellement supérieure ou égale à 100 nm. L'épaisseur de la première couche semiconductrice S1 permet de graver ladite couche S1 de manière à former la couche qubits tout en s'assurant que les piliers soient suffisamment haut pour dépasser les lignes et colonnes de couplage et la troisième couche de séparation. L'épaisseur de la première couche semiconductrice S1 peut être réduite ou augmentée selon que le circuit à fabriquer comporte plus ou moins de lignes/colonnes de couplage. Par exemple, des troisièmes électrodes conductrices, formant par exemple des diagonales de couplage, pourraient être ajoutées, nécessitant des piliers semiconducteurs plus grands pour qu'ils puissent dépasser la dernière couche de séparation.

Comme mentionné précédemment, la première couche semiconductrice S1 est en silicium monocristallin afin d'être compatible avec des procédés de fabrication standard dans le domaine. Le silicium de la première couche semiconductrice S1, s'il y a lieu, peut également être enrichi par un isotope tel que le silicium 28. Ce dernier permet d'augmenter le temps de cohérence intrinsèque de la couche qubits. La concentration de silicium 28 dans la première couche semiconductrice S1 est par exemple supérieure à 99,9 %.

La première couche semiconductrice S1 peut être obtenue à partir d'un substrat, par exemple de type SOI, comprenant une couche semiconductrice monocristalline en face avant FRT, une couche semiconductrice en face arrière BCK et une couche isolante BOX. La couche isolante est disposée entre les deux couches précédentes FRT, BCK, autrement dit, enterrée sous la couche semiconductrice en face avant FRT. Une épitaxie à partir de la couche semiconductrice monocristalline en face avant FRT permet d'obtenir une couche semiconductrice épitaxiée EPI. La couche semiconductrice monocristalline en face avant FRT et la couche semiconductrice épitaxiée EPI forment ainsi la première couche semiconductrice S1. Une épitaxie réalisée de préférence en pleine plaque permet de conserver la qualité cristalline de la couche semiconductrice en face avant FRT et ainsi obtenir une première couche semiconductrice S1 monocristalline. De plus, réaliser une épitaxie permet de contrôler l'épaisseur de la couche semiconductrice épitaxiée EPI et donc l'épaisseur de la première couche semiconductrice S1 sans recourir à une étape de gravure. La première couche semiconductrice S1 comprend alors la couche semiconductrice épitaxiée EPI et la couche semiconductrice en face avant FRT. Il est préférable que la première couche semiconductrice S1 présente une bonne qualité cristalline afin de fabriquer un circuit électronique quantique présentant de bonnes caractéristiques électroniques et une faible variabilité. C'est la raison pour laquelle il est préférable que la première couche semiconductrice soit obtenue en partie par épitaxie.

La couche semiconductrice épitaxiée EPI peut également être amincie elle est trop épaisse. Une méthode bien connue de la personne du métier, telle que des étapes successives d'oxydation/gravure, peut être mise en œuvre.

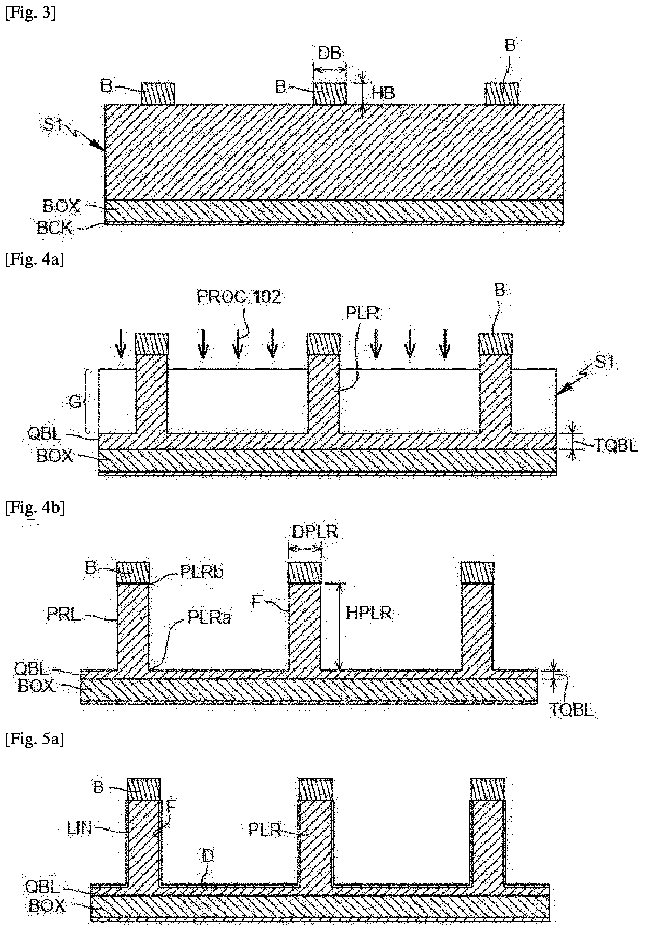

La [FIG. 4a] illustre la gravure PROC102 de la première couche semiconductrice S1 de manière à obtenir les piliers semiconducteurs et la couche qubits. Pour cela, une première partie G de la première couche semiconductrice S1 est gravée afin d'obtenir le circuit intermédiaire illustré en [FIG. 4b]. Afin d'obtenir la pluralité de piliers semiconducteurs PLR, ladite gravure PROC102 est avantageusement réalisée de manière anisotrope, c'est à dire selon une direction préférentielle, préférentiellement perpendiculaire à la surface libre de la première couche semiconductrice S1. Des plots de protection B en matériau dur, peuvent être disposés sur la surface de la première couche semiconductrice S1, pour protéger une partie de ladite couche S1 et permettre de former un pilier semiconducteur PLR sous chaque plot de protection B.

Un agencement particulier des qubits au sein de la couche qubits dans le circuit en fonctionnement permet de mettre en œuvre une méthode de correction d'erreurs appelée "surface code". Pour cela, les qubits sont préférentiellement agencés selon un réseau carré présentant un pas donné. Une première partie des qubits est destinée à former des qubits de données et une seconde partie des qubits est destinée à former des qubits de mesure. Les qubits de données et de mesure sont disposés de manière alternée formant ainsi un réseau de qubits de données en quinconce et un réseau de qubits de mesure en quinconce. Les réseaux de qubits en quinconce présentent ainsi un pas double par rapport au pas du réseau carré. Seul les qubits de mesure sont destinés à être disposés à l'aplomb des piliers semiconducteurs PLR, il est ainsi avantageux de disposer également ces derniers en quinconce.

La gravure PROC102 de la première partie G de la première couche semiconductrice S1 est également réalisée de manière à conserver une deuxième partie QBL de la première couche semiconductrice S1, dite couche qubits. Par conserver, on entend que la gravure PROC102 est par exemple arrêtée avant que toute l'épaisseur de la première couche semiconductrice S1 ne soit gravée. Ladite gravure PROC102 est réalisée de sorte que l'épaisseur TQBL de la couche qubits QBL soit préférentiellement comprise entre 5 nm et 35 nm, de préférence entre 10 nm et 20 nm, par exemple égale à 15 nm.

La pluralité de piliers semiconducteurs PLR, tels qu'illustrés par la [FIG.4b], reposent ainsi sur la couche qubits QBL. Une première extrémité PLRa de chaque pilier semiconducteur PLR, que l'on appellera "base", repose sur la couche qubit QBL. Une deuxième extrémité PLRb de chaque pilier semiconducteur PLR, que l'on appellera "tête", est préférentiellement disposée sous un plot de protection B. La gravure PROC102 de la première partie G de la première couche semiconductrice S1 permet ainsi d'obtenir une continuité cristalline entre les piliers PLR et la couche qubits QBL au niveau de chaque base PLRa des piliers PLR. La première couche semiconductrice S1 étant monocristalline, la couche qubits QBL et les piliers PLR sont donc réalisés dans le même cristal. Chaque pilier PLR peut présenter une hauteur HPLR, mesurée perpendiculairement à la couche qubits QBL, supérieure à 50 nm et préférentiellement supérieure ou égale à 80 nm.

Chaque pilier semiconducteur PLR peut présenter un ou plusieurs flancs F selon que ce dernier soit cylindrique ou parallélépipédique. Afin de simplification dans le reste de la description, il ne sera fait mention que "du flanc" d'un pilier semiconducteur pour désigner le flanc ou les flancs dudit pilier, selon que ce dernier soit cylindrique ou parallélépipédique. Lorsque la gravure PROC102 met en œuvre des plots de protection B, le flanc F de chaque pilier PLR est ainsi disposé à l'aplomb du pourtour de chaque plot de protection B. Le diamètre DPLR de chaque pilier PLR peut coïncider avec le diamètre de chaque plot de protection B et est par exemple compris entre 30 nm et 60 nm, par exemple égal à 50 nm. Le diamètre DPLR de chaque pilier PLR peut également être inférieure au diamètre de chaque plot de protection B, notamment lorsque la gravure mise en œuvre n'est pas totalement anisotrope. Ainsi le flanc de chaque pilier PLR est légèrement en retrait de l'aplomb du pourtour de chaque plot B.

Le procédé PROC comporte avantageusement, avant la gravure PROC102 de la première couche semiconductrice S1, la formation PROC101 de la pluralité de plots de protection B sur la première couche semiconductrice S1. La [FIG. 3] présente schématiquement la formation PROC101 de la pluralité de plots de protection B sur la première couche semiconductrice S1. Les plots de protection B sont préférentiellement formés par dépôt de la couche de masque dur, suivi de la photolithographie d'un masque de résine et gravure anisotrope des plots B à travers le masque de résine. Les plots de protection B peuvent également être formés par photolithographie d'un masque de résine et dépôt d'une couche dite de masque dur, par exemple de SiN. De préférence, les plots de protection B présentent un contour pouvant être circulaire ou rectangulaire. Chaque plot de protection B présente une hauteur HB, mesurée perpendiculairement à la surface de la première couche semiconductrice S1, pouvant être comprise entre 20 nm et 80 nm. Lorsque les plots de protection B sont cylindriques, ils présentent chacun un diamètre DB pouvant être compris entre 30 nm et 60 nm. Lorsque les plots de protection B sont parallélépipédiques, ils présentent chacun une diagonale pouvant être compris entre 30 nm et 60 nm. Afin de simplification dans la description, on désignera par "diamètre" tant le diamètre des plots cylindriques que la diagonale des plots parallélépipédiques.

Afin de former les piliers semiconducteurs PLR en quinconce par rapport au réseau de qubits, il est avantageux de disposer les plots de protection B en quinconce sur la première couche semiconductrice S1.

Lorsque le procédé PROC est réalisé sur un substrat de type SOI, la couche qubits QBL s'étend alors sur la couche isolante BOX et plus particulièrement entre la pluralité de piliers semiconducteurs PLR et la couche isolante BOX.

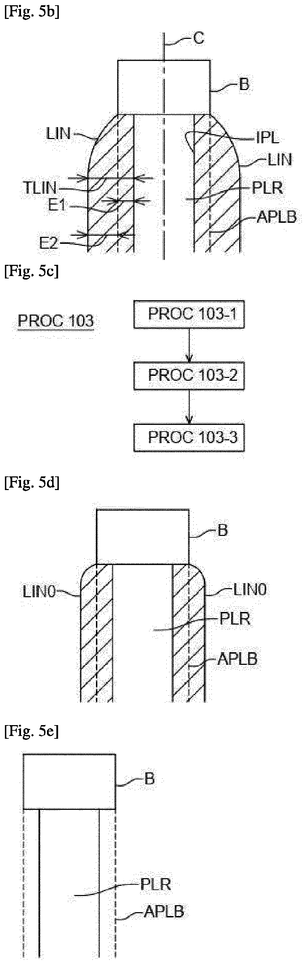

La [FIG. 5a] illustre une première mise en œuvre de l'oxydation PROC103 du flanc F de chaque pilier PLR. Ladite oxydation PROC103 est réalisée de manière à former, au niveau de chaque flanc, une première couche diélectrique LIN, dite "diélectrique de flanc". Chaque pilier PLR est ainsi entouré d'un diélectrique de flanc LIN. Ladite oxydation PROC103 est préférentiellement réalisée par oxydation thermique, telle qu'illustrée par la [FIG. 5b]. De cette manière, un diélectrique de flanc LIN enrobe complètement le flanc de chaque pilier semiconducteur PLR. L'épaisseur TLIN de chaque diélectrique de flanc LIN, mesurée perpendiculairement à la surface libre le diélectrique de flanc LIN, est préférentiellement comprise entre 5 nm et 10 nm. L'oxydation PROC103 peut également former une couche diélectrique D sur la couche qubits QBL. Cette dernière présente un moindre intérêt puisqu'elle sera recouverte par la première couche de séparation. En revanche, une oxydation thermique forme un oxyde de meilleur qualité qu'un oxyde déposé. Il est donc avantageux de ne pas retirer ladite couche diélectrique D sur la couche qubits QBL avant de déposer la première couche de séparation.

L'oxydation thermique a pour effet de transformer une partie du matériau semiconducteur de chaque pilier PLR en matériau diélectrique. L'interface IPL entre le matériau semiconducteur et le diélectrique de chaque pilier PLR n'est pas à l'aplomb APLB du plot de protection B mais légèrement en retrait, rapprochée du centre C de chaque pilier PLR. Sur la [FIG. 5b], l'interface IPL entre un pilier PLR et un diélectrique de flanc LIN est déplacée d'une distance E1 par rapport à l'aplomb APLB du plot de protection B, en direction du centre C dudit pilier PLR. Le retrait de l'interface IPL par rapport à l'aplomb APLB permet de protéger le matériau semiconducteur du pilier PLR lors des étapes suivantes du procédé PROC, notamment les étapes mettant en œuvre une gravure anisotrope. Ainsi, l'intégrité cristalline du pilier PLR et ses propriétés cristalline sont préservées. De plus, un partie du diélectrique de flanc LIN est masquée par le plot de protection B et est ainsi protégée des étapes suivantes de gravure. Une oxydation thermique forme un oxyde de meilleur qualité, il est donc avantageux de conserver un tel oxyde au niveau du flanc de chaque pilier.

En revanche, le volume de matériau oxydé peut croître lors de l'oxydation thermique, si bien que la surface libre de chaque diélectrique de flanc LIN peut être distante de l'aplomb APLB du plot de protection B et légèrement exposée par rapport audit plot B. Sur la [FIG. 5b], la surface libre d'un diélectrique de flanc LIN est distante de l'aplomb APLB du plot de protection B d'une distance E2. Ainsi, les étapes suivantes du procédé PROC, mettant en œuvre une gravure anisotrope, peuvent également graver la partie exposée dudit diélectrique de flanc LIN.

Les lignes et colonnes de couplage, réalisée dans un deuxième temps, forment avec chaque diélectrique de flanc LIN une grille au niveau de chaque pilier PLR. Il est donc avantageux, pour réduire la variabilité des circuits fabriqués, de contrôler l'épaisseur TLIN de chaque diélectrique de flanc LIN. Il est plus aisé de contrôler l'épaisseur de chaque diélectrique de flanc LIN pendant leur formation, c'est à dire pendant l'étape d'oxydation PROC103, que lors d'une gravure anisotrope.

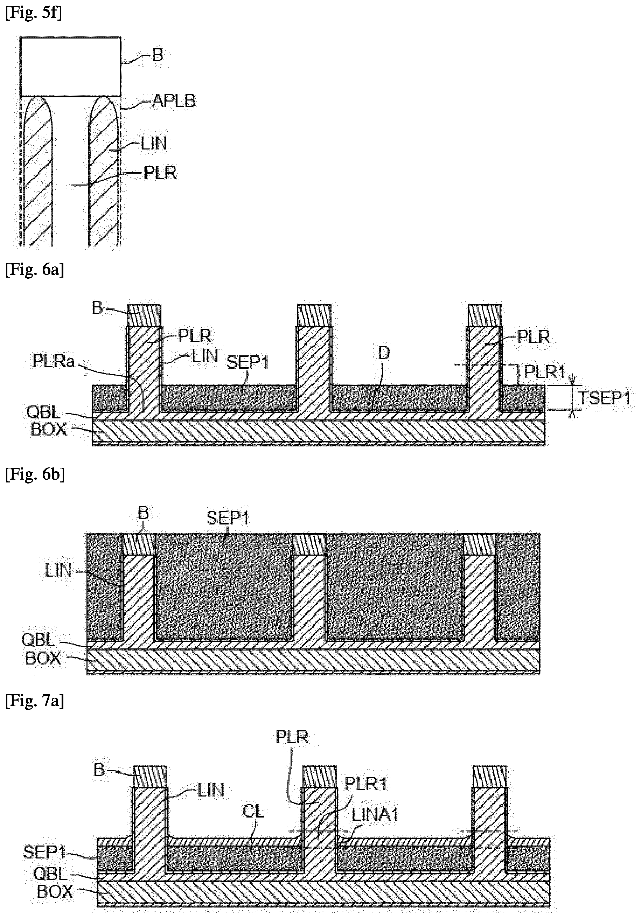

Les [FIG. 5c], [FIG. 5d], [FIG. 5e] et [FIG. 5f] illustrent une variante de mise en œuvre de l'étape d'oxydation PROC103 permettant d'améliorer la variabilité des circuits fabriqués. Selon cette variante, l'étape d'oxydation PROC103 comprend une première sous-étape d'oxydation PROC103-1 du flanc F de chaque pilier PLR de manière à former, au niveau du flanc de chaque pilier PLR, une première couche diélectrique sacrificielle LINO. Chaque première couche diélectrique sacrificielle LINO est ensuite retirée lors d'une deuxième sous-étape PROC103-2, préférentiellement par gravure isotrope, pour libérer la surface libre de chaque pilier PLR. Enfin, une troisième sous-étape d'oxydation PROC103-3 de la surface nouvellement libérée de chaque pilier PLR permet ainsi de former, au niveau du flanc de chaque pilier PLR, un diélectrique de flanc LIN final. Grâce à la gravure 103-2 de la première couche sacrificielle LINO et la réoxydation 103-3 du flanc des piliers PLR, la surface libre de chaque diélectrique de flanc LIN est à l'aplomb APLB du plot de protection, ou légèrement en retrait. Ainsi, les étapes suivantes du procédé PROC, pouvant mettre en œuvre une gravure anisotrope, ne détériorent pas ou n'amincissent pas les diélectriques de flanc LIN. De cette manière, la variabilité de comportement des grilles formées avec les lignes et colonnes de couplage est réduite.

La [FIG. 6a] illustre le dépôt PROC104 de la première couche de séparation SEP1, sur la couche qubits QBL. Lorsqu'une couche diélectrique D est formée lors de l'étape d'oxydation PROC103, et qu'elle n'est pas retirée avant la formation de la première couche de séparation SEP1, alors ladite couche de séparation SEP1 est avantageusement déposée sur la couche diélectrique D recouvrant la couche qubits. La première couche de séparation SEP1 peut être réalisée à partir d'oxyde de silicium SiO₂. Pour cela, la première couche de séparation SEP1 peut être déposée, dans un premier temps, de manière à recouvrir intégralement les piliers PLR ainsi que les plots de protection B, telle qu'illustrée par la [FIG. 6b]. Un aplanissement et une gravure anisotrope de la première couche de séparation SEP1 permettent de contrôler l'épaisseur de ladite couche SEP1. L'aplanissement, par exemple par polissage mécanique et/ou chimique, s'arrête au sommet des plots de protection B. La gravure de la première couche de séparation SEP1 aplanie est arrêtée avant d'atteindre la couche qubits QBL. L'épaisseur finale TSEP1 de la première couche de séparation SEP1, mesurée à partir de la couche qubit QBL, est alors préférentiellement comprise entre 20 nm et 40 nm. Ainsi, au moins une première portion PLR1 de chaque pilier PLR dépasse de la première couche de séparation SEP1. Le dépôt PROC104 peut être réalisé par dépôt chimique en phase vapeur (ou "CVD" en anglais) et/ou dépôt chimique assisté par plasma. À l'issue de l'étape dudit dépôt PROC104, la première couche de séparation SEP1 recouvre et entoure la base PLRa de chaque pilier PLR.

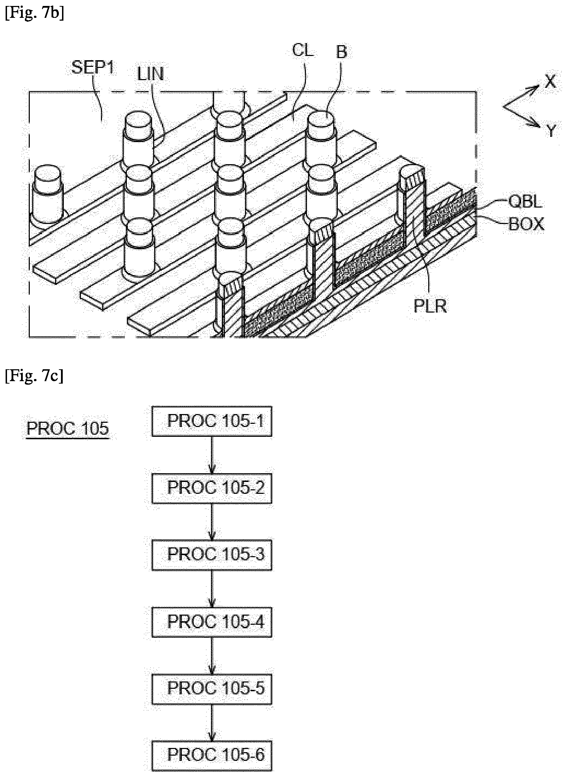

Les [FIG. 7a] et [FIG. 7b] illustrent une structure issue de l'étape de formation PROC105 de la pluralité de lignes de couplage CL. Les lignes de couplage CL sont destinées à appliquer un champ électrostatique sur chaque première portion PLR1 de pilier dépassant de la première couche de séparation SEP1, permettant de permettre ou bloquer le passage d'électrons dans le pilier PLR vers le qubit ou à partir du qubit. Pour cela, elles forment avantageusement, avec les diélectriques de flanc LIN, une grille au niveau de chaque première portion PLR1 du pilier PLR. Afin d'améliorer le couplage de chaque ligne de couplage CL avec un pilier PLR, il est préférable que chaque ligne de couplage CL entoure une première portion annulaire LINA1 du diélectrique de flanc LIN, préférentiellement au niveau de la première portion PRL1 du pilier PLR. Pour cela, chaque ligne de couplage CL est en contact avec le diélectrique de flanc LIN entourant au moins un pilier PLR. De préférence, chaque ligne de couplage CL est formée PROC105 de manière à entourer une première portion annulaire LINA1 d'au moins un diélectrique de flanc LIN dépassant de la première couche de séparation SEP1. Chaque ligne de couplage CL est en contact avec au moins un diélectrique de flanc LIN. Chaque ligne de couplage CL peut également être en contact avec une pluralité de diélectriques de flanc LIN. De la sorte, une ligne de couplage CL peut appliquer un champ électrostatique à une pluralité de piliers PLR. En combinaison avec les colonnes de couplage (décrites ci-après), elle permet l'indexation de chaque pilier PLR et donc de chaque qubit de manière indépendante. Les piliers PLR étant disposés en quinconce, chaque ligne de couplage CL peut contacter un pluralité de diélectriques de flanc LIN en s'étendant selon une première direction X coïncidant avec une ligne de piliers PLR. La [FIG. 7b] illustre une vue 3D des piliers PLR et des lignes de couplages CL obtenues à l'issue de leur formation PROC105. Les piliers sont agencés en quinconce formant des lignes selon la première direction X et des colonnes selon une deuxième direction Y.

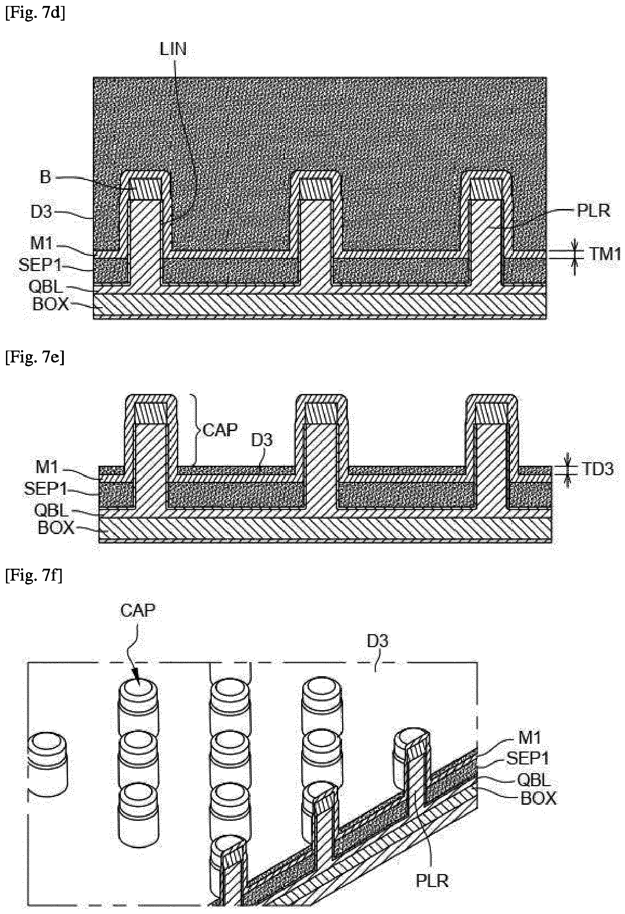

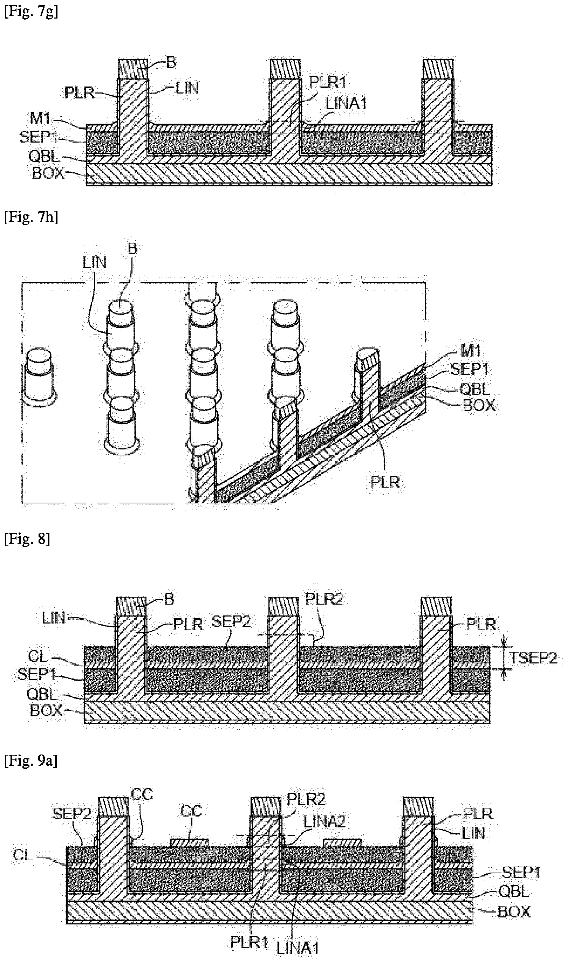

Une variante de réalisation de l'étape de formation PROC105 est détaillée par la [FIG. 7c] et illustrée par les [FIG. 7d] à [FIG. 7h]. L'étape de formation PROC105 peut comprendre un premier dépôt PROC105-1 conforme d'une première couche conductrice M1, par exemple en silicium polycristallin dopé ou en nitrure de titane. Le premier dépôt PROC105-1 est préférentiellement conforme et permet de recouvrir intégralement la première couche de séparation SEP1, les diélectriques de flanc LIN et les plots de protection B. La première couche conductrice M1 peut présenter une épaisseur TM1 comprise entre 10 nm à 15 nm. L'étape de formation PROC105 peut comprendre un dépôt PROC105-2 d'une cinquième couche de diélectrique D3, illustrée par la [FIG. 7d], par exemple en oxyde de silicium, de manière à recouvrir complètement l'ensemble.

L'étape de formation PROC105 peut également comprendre une gravure PROC105-3 de la cinquième couche diélectrique D3, telle qu'illustrée par les [FIG. 7e] et [FIG. 7f], réalisée de manière anisotrope et sélective par rapport à la première couche conductrice M1. La première gravure PROC105-3 permet de mettre à nu une pluralité de portions CAP de la première couche conductrice M1, dites "capuchons". Chaque capuchon CAP recouvre un plot de protection B et une portion supérieure d'un pilier PLR. La gravure PROC105-3 de la cinquième couche diélectrique D3 est arrêtée de manière à laisser une épaisseur résiduelle TD3 de 10 nm à 15 nm, à la base de chaque capuchon CAP.

L'étape de formation PROC105 peut également comprendre une gravure PROC105-4 de la première couche conductrice M1 et de la cinquième couche diélectrique D3, telle qu'illustrée par les [FIG. 7g] et [FIG. 7h], de manière à retirer la pluralité de capuchons CAP ainsi que l'épaisseur résiduelle TD3 de la cinquième couche diélectrique D3. La première couche conductrice M1 restante s'étend alors sur la première couche de séparation SEP1 et entoure une première portion annulaire LINA1 de chaque diélectrique de flanc LIN.

La gravure PROC105-4 de la première couche conductrice M1 peut être réalisée en une seule fois, par exemple par gravure non sélective et isotrope, permettant de retirer dans un même temps la pluralité de capuchons CAP et l'épaisseur résiduelle TD3 de la cinquième couche diélectrique D3. L'épaisseur résiduelle TD3 de la cinquième couche diélectrique D3 est alors avantageusement choisie de sorte qu'elle soit complètement retirée lorsque les capuchons CAP sont retirés.

La gravure PROC105-4 peut également être réalisée en deux sous-étapes. Une première sous-étape comprenant une gravure sélective de la première couche conductrice M1 par rapport à l'épaisseur résiduelle TD3 de la cinquième couche diélectrique D3 de manière à retirer les capuchons CAP. Une deuxième sous-étape comprenant une gravure anisotrope de l'épaisseur résiduelle TD3 de la cinquième couche diélectrique D3 de manière à retirer la cinquième couche diélectrique D3. N'étant pas réalisée de manière sélective, la deuxième sous-étape est arrêtée avant de graver substantiellement la première couche conductrice M1.

Afin de finaliser les lignes de couplage CL, telles qu'illustrées par la [FIG. 7b], l'étape de formation PROC105 peut comprendre la gravure PROC105-6 de la première couche conductrice M1 à travers ce masque de résine de manière à obtenir les lignes de couplage CL. L'étape de formation PROC105 peut par exemple comprendre, avant ladite gravure PROC105-6, une photolithographie PROC105-5 d'un masque de résine sur la première couche conductrice M1, suivi de la gravure PROC105-6 de la première couche conductrice M1 à travers le masque de résine de manière à obtenir les lignes de couplage CL. Les lignes de couplages sont préférentiellement sensiblement parallèles les unes aux autres et s'étendent préférentiellement selon la première direction X. Par sensiblement parallèle, on entend à ± 30° près, préférentiellement à ± 20° près, voire à ± 10° près.

Selon une variante de la gravure PROC105-4 de la première couche conductrice M1, seuls les capuchons CAP sont retirés, par exemple par gravure sélective. L'épaisseur résiduelle TD3 de la cinquième couche diélectrique D3 est alors utilisée pour former un masque lors de la sous-étape de photolithographie PROC105-5 précitée et permettre ainsi la gravure PROC105-6 des lignes de couplage CL à travers ledit masque. La cinquième couche diélectrique D3 est retirée, par exemple par gravure sélective, après l'obtention des lignes de couplage CL.

La [FIG. 8] présente schématiquement l'étape de dépôt PROC106 de la deuxième couche de séparation SEP2. La deuxième couche de séparation SEP2 est déposée de manière à recouvrir la pluralité de lignes de couplage CL, assurant ainsi leur isolation électrique. La deuxième couche de séparation SEP2 peut également être déposée de manière à recouvrir la première couche de séparation SEP1. Le dépôt PROC106 de la deuxième couche de séparation SEP2 est avantageusement réalisé de la même manière que le dépôt de la première couche de séparation SEP1, tel qu'illustré par les [FIG. 6a] et [FIG. 6b]. La deuxième couche de séparation SEP2 peut par exemple être réalisée à partir d'oxyde de silicium SiO₂. L'épaisseur TSEP2 de la deuxième couche de séparation SEP2 est préférentiellement comprise entre 20 nm et 40 nm. Ladite épaisseur TSEP2 est mesurée depuis la première couche de séparation SEP1 sur laquelle reposent les lignes de couplage CL.

L'épaisseur TSEP2 de la deuxième couche de séparation SEP2 est préférentiellement choisie de sorte qu'au moins une deuxième portion PLR2 de chaque pilier PLR dépasse de la deuxième couche de séparation SEP2.

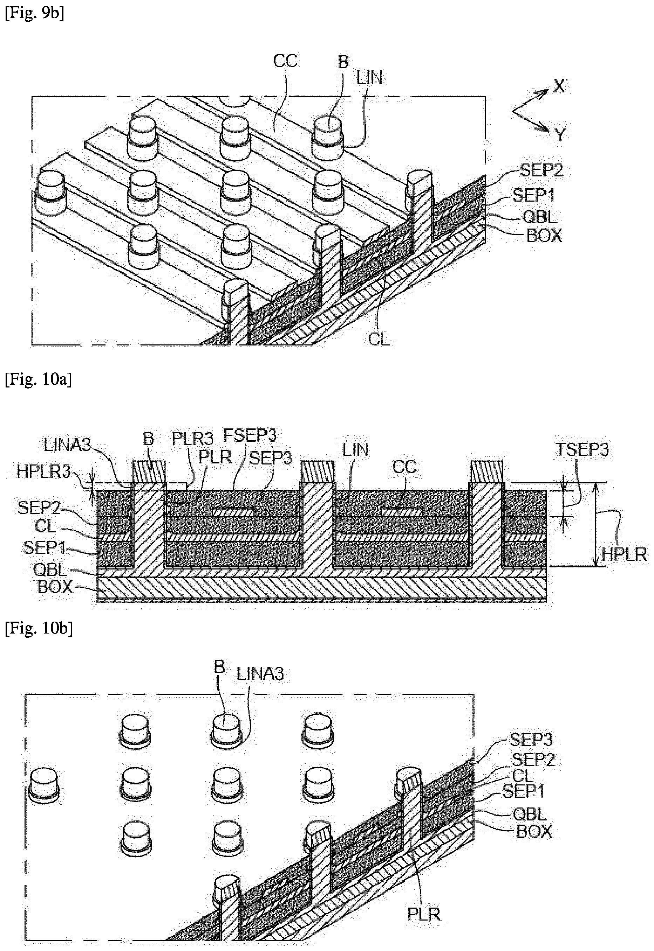

Les [FIG. 9a] et [FIG. 9b] illustrent l'étape de formation PROC107 de la pluralité colonnes de couplage CC. De la même manière que les lignes de couplage CL, Les colonnes de couplage CC forment avantageusement, avec les diélectriques de flanc LIN, une grille au niveau de chaque pilier PLR. Les lignes et les colonnes de couplage CL, CC sont ainsi destinées à appliquer un champ électrostatique sur les première et deuxième portions PLR1, PLR2 d'un même pilier PLR, permettant d'autoriser ou bloquer le passage d'électrons dans ledit pilier PLR. Les lignes et colonnes de couplage CL, CC sont agencées de sorte qu'appliquer un potentiel électrique à l'une des lignes CL et l'une des colonnes CC permet d'autoriser ou bloquer le passage d'électrons d'un seul pilier PLR parmi la pluralité de piliers PLR. Les lignes et colonnes de couplage CL, CC permettent ainsi l'indexation individuelle des qubits pour, par exemple, initialiser ou mesurer leur état.

Il est ainsi également avantageux que le couplage de chaque colonne de couplage CC avec les piliers PLR soit reproductible et maximal. Il est ainsi préférable que les colonnes de couplage CC entourent, de la même manière que les lignes de couplage CL, une deuxième portion annulaire LINA2 d'un diélectrique de flanc LIN et donc la deuxième portion PLR2 d'un pilier PLR. Pour cela, chaque colonne de couplage CC est en contact avec au moins un diélectrique de flanc LIN. De préférence, chaque colonne de couplage CC est formée PROC107 de manière à entourer une deuxième portion annulaire LINA2 d'au moins un diélectrique de flanc LIN, dépassant de la deuxième couche de séparation SEP2.

Les colonnes de couplage CC s'étendent avantageusement sur la deuxième couche de séparation SEP2. Cette dernière, recouvrant les lignes de couplage CL, permet d'assurer une isolation électrique entre les lignes et les colonnes de couplage CL, CC. Toutefois, il peut subsister un couplage capacitif entre les lignes et les colonnes de couplages CL, CC. Afin de réduire le couplage capacitif, il est avantageux que les colonnes de couplage CC soient réalisées de manière à croiser les lignes de couplages CL selon un angle sensiblement droit. Par angle sensiblement droit, on entend droit à ± 30° près, préférentiellement à ± 20° près, voire à ± 10° près.

Ainsi, les colonnes de couplage CC s'étendent préférentiellement parallèlement entre elles et selon la deuxième direction Y. Ainsi, elles peuvent contacter les diélectriques de flanc LIN d'une pluralité de piliers PLR alignés selon la deuxième direction Y et réduire le couplage capacitif avec les lignes de couplages CL.

La [FIG. 9b] illustre une vue 3D des piliers PLR, des lignes de couplage CL et des colonnes de couplages CC obtenues à l'issue de l'étape de formation PROC107 des colonnes CC.

Les piliers étant agencés en quinconce et formant des lignes et des colonnes selon, respectivement, la première direction X et la deuxième direction Y, les colonnes de couplages CC sont alors préférentiellement orientées perpendiculairement aux lignes de couplage CL. Il est toutefois envisageable que les colonnes de couplage CC forment un autre angle avec les lignes de couplage CL, par exemple égal à 45°. Auquel cas, les deuxièmes électrodes conductrices CC sont appelées "diagonales de couplage".

L'étape de formation PROC107 des colonnes de couplage CC est préférentiellement similaire à l'étape de formation PROC105 des lignes de couplage CL telle qu'illustrée par les [FIG. 7a] à [FIG. 7h].

Les [FIG. 10a] et [FIG. 10b] illustrent l'étape de dépôt PROC108 de la troisième couche de séparation SEP3. Ladite troisième couche de séparation SEP3 repose sur la pluralité de colonnes de couplage CC et enrobe ladite pluralité de colonnes CC. Le dépôt PROC108 de la troisième couche de séparation SEP3 peut être réalisée de la même manière que le dépôt PROC105 de la première couche de séparation SEP1, tel qu'illustré par les [FIG. 6a] et [FIG. 6b] et/ou le dépôt PROC107 de la deuxième couche de séparation SEP2. La troisième couche de séparation SEP3 peut également être réalisée à partir d'oxyde de silicium SiO₂. La troisième couche de séparation SEP3 enrobe les colonnes de couplage CC et peut également recouvrir la deuxième couche de séparation SEP2. Aussi, la troisième couche de séparation SEP3 présente une épaisseur TSEP3 mesurée à partir de la deuxième couche de séparation SEP2 sur laquelle repose les colonnes de couplage CC.

À la différence des première et deuxième couches de séparation SEP1, SEP2, l'épaisseur TSEP3 de la troisième couche de séparation SEP3 est configurée pour qu'une troisième portion PLR3 de chaque pilier PLR dépasse de ladite troisième couche de séparation SEP3. De la sorte, une troisième portion annulaire LINA3 de chaque diélectrique de flanc LIN, entourant la troisième portion PLR3 de chaque pilier PLR, dépasse également de ladite troisième couche SEP3. La troisième portion annulaire LINA3 s'étend alors sur toute la hauteur HLPR3 de la troisième portion PLR3 de pilier PLR, c'est à dire de la surface libre FSEP3 de la troisième couche SEP3 jusqu'au sommet de chaque pilier PLR, affleurant ainsi les plots de protection B posés sur chaque pilier PLR. L'épaisseur TSEP3 de la troisième couche de séparation SEP3 et/ou la hauteur HPLR de chaque pilier PLR est choisie de sorte que la hauteur HPLR3 de la troisième portion PLR3 soit comprise entre 5 nm et 20 nm inclus, par exemple 10 nm. L'épaisseur TSEP3 de la troisième couche de séparation SEP3 peut être comprise entre 20 nm et 40 nm.

Afin d'ajuster l'épaisseur TSEP3 de la troisième couche de séparation SEP3, elle peut être, dans un premier temps, déposée de manière à dépasser le sommet des plots de protection B. Dans un second temps, elle peut être aplanie jusqu'à affleurer le sommet des plots de protection B. Enfin, la troisième couche de séparation SEP3 peut être gravée de manière anisotrope afin de mettre à nu les plots de protection B et la troisième portion annulaire LINA3 de chaque diélectrique de flanc LIN.

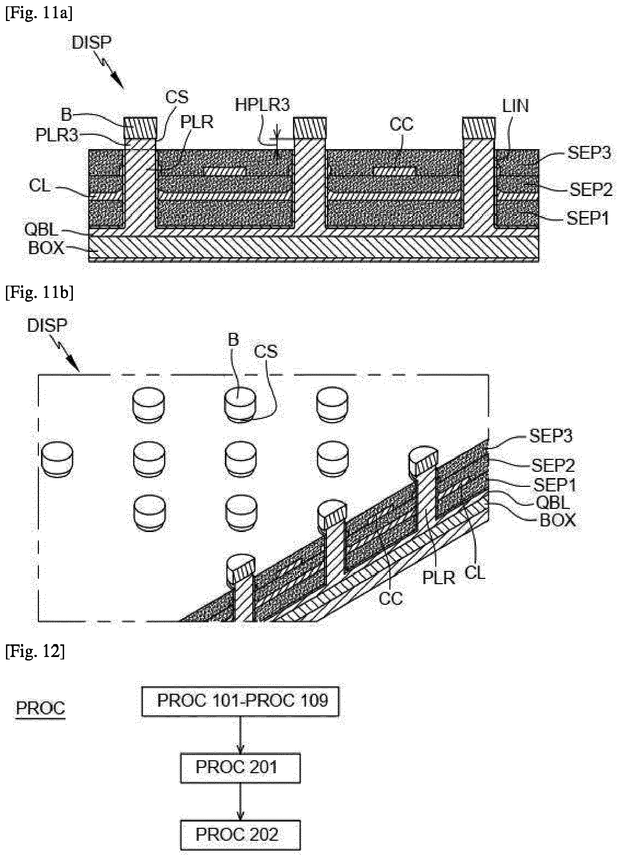

Les [FIG. 11a] et [FIG. 11b] illustrent la gravure PROC109 des troisièmes portions annulaires LINA3 de chaque diélectrique de flanc LIN de manière à mettre à nu la troisième portion PLR3 de chaque pilier PLR. La troisième portion PLR3 de pilier expose ainsi une surface de contact CS, dite "surface de contact". La surface de contact CS peut être utilisée pour connecter électriquement le pilier PLR à une électrode conductrice de manière à permettre le passage d'électrons vers ou à partir de la couche qubit QBL. La surface de contact CS peut également être connectée à un dispositif de lecture de l'état quantique d'un qubit, permettant de lire l'état du qubit situé à l'aplomb dudit pilier PLR.

La gravure PROC109 des troisièmes portions annulaires LINA3 de chaque diélectrique de flanc LIN est préférentiellement réalisée de manière à les retirer complètement. Pour cela, ladite gravure PROC109 peut être réalisée sélectivement, au moins par rapport aux plots de protection B. Lorsque les diélectriques de flanc LIN sont composés de SiO₂, la gravure PROC109 peut être réalisée au moyen d'acide fluorhydrique HF dilué.

Le procédé PROC permet ainsi de fabriquer un circuit électronique quantique DISP comprenant une couche qubit QBL et une pluralité de pilier PLR réalisés à partir d'un seul et même cristal et pouvant être intégré dans un système électronique quantique.

En d'autres termes, le circuit électronique quantique DISP obtenu à l'aide du procédé PROC selon l'invention comprend alors :
- une couche qubits QBL ;
- une pluralité de piliers semiconducteurs PLR, la base de chaque pilier semiconducteur PLR étant en contact avec la couche qubits QBL ;
- une pluralité de diélectriques de flanc LIN, chaque diélectrique de flanc LIN entourant le flanc de chaque pilier semiconducteur PLR tout en laissant exposée une surface du flanc de chaque pilier semiconducteur PLR au niveau de la tête dudit pilier semiconducteur PLR ;
- une première couche de séparation SEP1 s'étendant sur la couche qubits QBL ;
- une pluralité de lignes de couplage CL s'étendant sur la première couche de séparation SEP1, chaque lignes de couplage CL étant en contact avec le diélectrique de flanc LIN d'au moins un pilier semiconducteur PLR ;
- une deuxième couche de séparation SEP2 s'étendant sur la première couche de séparation SEP1 et enrobant la pluralité de lignes de couplage CL;
- une pluralité de colonnes de couplage CC s'étendant sur la deuxième couche de séparation SEP3, chaque colonne de couplage CC étant en contact avec le diélectrique de flanc LIN d'au moins un pilier semiconducteur PLR ;
- une troisième couche de séparation SEP3 s'étendant sur la deuxième couche de séparation SEP2 et enrobant la pluralité de colonnes de couplage CC et laissant exposée la tête une surface de chaque pilier semiconducteur PLR.

Ledit circuit DISP est remarquable en ce que la couche qubits QBL et chaque pilier semiconducteur PLR appartiennent à un même matériau semiconducteur monocristallin et présentent ainsi une continuité cristalline.

La [FIG. 12] présente schématiquement un deuxième mode de mise en œuvre du procédé PROC de fabrication, permettant d'obtenir un circuit DISP électronique quantique selon un deuxième mode de réalisation. À la différence du premier mode de mise en œuvre PROC101 - PROC109, le procédé PROC selon le deuxième mode de mise en œuvre comprend les étapes supplémentaires suivantes :
- retirer PROC201 chaque plot de protection B ; et
- déposer PROC202 une deuxième couche conductrice dopée INI, dite "couche d'initialisation".

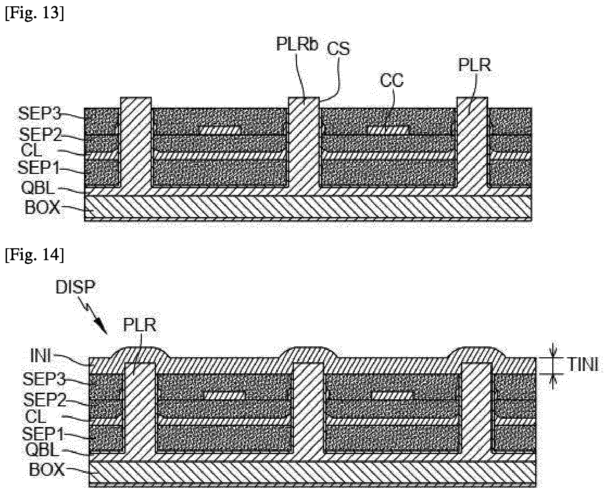

La [FIG. 13] illustre le retrait PROC201 de chaque plot de protection B, de manière à libérer la tête PLRb de chaque pilier PLR. Le retrait des plots sacrificiel B peut être réalisé par gravure sélective par rapport à chaque pilier PLR et/ou la troisième couche de séparation. Lorsque les plots de protection B sont en nitrure de silicium, la gravure peut par exemple être réalisée au moyen d'acide phosphorique H₃PO₄.

La [FIG. 14] illustre le dépôt PROC202 de la couche d'initialisation INI de sorte qu'elle soit en contact avec chaque pilier PLR. Elle recouvre par exemple au moins les têtes PLRb et les surfaces de contact CS de chaque pilier PLR. De cette manière la couche d'initialisation INI est en contact électrique avec chaque pilier PLR et permet de fonctionner comme un réservoir d'électrons afin d'initialiser chaque qubits à l'aplomb des piliers PLR connectés. La couche d'initialisation INI est par exemple réalisée à partir de silicium polycristallin fortement dopé. Son épaisseur TINI est préférentiellement comprise entre 20 nm et 40 nm.

Afin d'améliorer l'interface au niveau du contact entre chaque pilier PLR et la couche d'initialisation INI, le dépôt PROC202 de la couche d'initialisation INI peut comprendre le dépôt par épitaxie de silicium dopé au phosphore Si:P ou de silicium et germanium dopé au bore SiGe:B. L'épitaxie est préférentiellement réalisée sélectivement afin d'être amorcée à partir de l'extrémité exposée de chaque pilier PLR, c'est à dire leur tête PLRb et leur surface de contact CS.

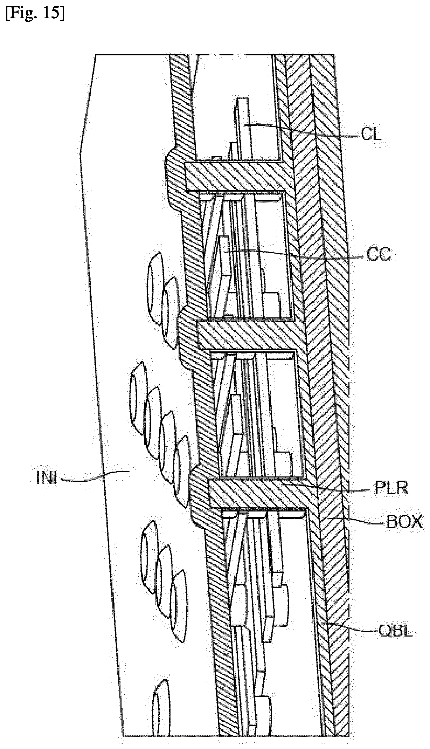

Le dépôt PROC202 de la couche d'initialisation INI peut également comprendre une étape de siliciuration de ladite couche d'initialisation INI, après le dépôt à proprement parler de ladite couche INI. La siliciuration est par exemple réalisée au moyen de nitrure de platine NiPt.La [FIG. 15] présente schématiquement le dispositif électronique quantique DISP susceptible d'être obtenu à l'issue du procédé de fabrication selon le deuxième mode de mise en œuvre. Les première, deuxième et troisième couches de séparation SPE1, SEP2, SEP3 sont masquées afin de présenter, par rapport à chaque pilier PLR et à la couche qubit QBL, la superposition des lignes de couplage CL, des colonnes de couplages CC et de la couche d'initialisation INI.

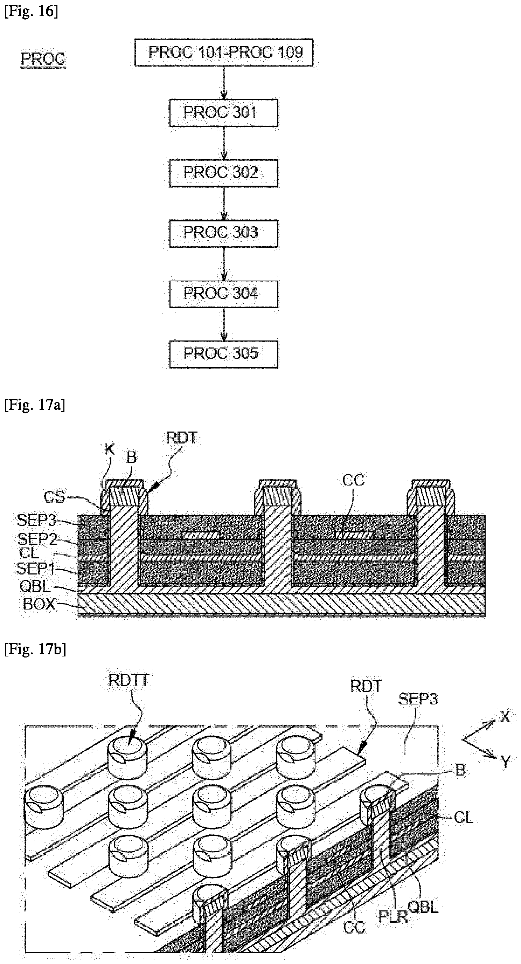

Le mode de réalisation du circuit DISP de la [FIG. 15] diffère ainsi du mode de réalisation des [FIG. 11a] et [FIG. 11b] en ce que le circuit DISP comprend également une couche d'initialisation INI contact avec chaque pilier semiconducteur PLR. La [FIG. 16] présente schématiquement un troisième mode de mise en œuvre du procédé PROC de fabrication, permettant d'obtenir le circuit DISP électronique quantique selon un troisième mode de réalisation. À la différence du premier mode de mise en œuvre PROC101 - PROC109 et du second mode de réalisation PROC 101 - PROC202, le procédé PROC selon le troisième mode de réalisation permet d'obtenir un circuit électronique quantique DISP comprenant une couche de lecture ainsi qu'un transistor à électron unique au niveau du sommet de chaque pilier PLR.

Selon le troisième mode de mise en œuvre, le procédé PROC comprend les étapes supplémentaires suivantes :
- former PROC301 une pluralité de troisièmes électrodes RDT conductrice dopée, dites "lignes de lecture" ;
- déposer PROC302 une sixième couche diélectrique SEP4, dite "quatrième couche de séparation", recouvrant les lignes de lecture RDT ;
- aplanir PROC303 la sixième couche de séparation SEP4 et la pluralité de lignes de lecture RDT jusqu'à atteindre les plots de protection B ;
- graver PROC304 sélectivement la pluralité de plots de protection B de manière à créer une pluralité de cavités ; et
- former PROC305 une structure de grille, "dite grille de chargement", dans chaque cavité.

Les [FIG. 17a] et [FIG. 17b] illustrent la formation PROC301 des lignes de lecture RDT. Chaque ligne de lecture RDT formée est préférentiellement au moins en contact avec un pilier PLR. Afin d'obtenir un bon contact électrique entre les lignes de lecture et les pilier PLR, il est avantageux que chaque ligne de lecture RDT soit en contact avec la surface de contact CS d'un pilier PLR. Dans l'exemple de la [FIG. 17b], les lignes de lecture RDT s'étendent selon la première direction X et connectent la surface de contact CS d'une pluralité de piliers PLR. Chaque ligne de lecture RDT peut également être en contact avec le flanc K d'un plot de protection B. Dans l'exemple des [FIG. 17a] et [FIG. 17b], les lignes de lecture RDT s'étendent sur la troisième couche de séparation SEP3 et recouvrent le chaque plot de protection B.

Afin de réduire le couplage capacitif entre les colonnes de couplage CC et les lignes de lecture RDT, ces dernières sont avantageusement orientées perpendiculairement aux colonnes de couplage CC.

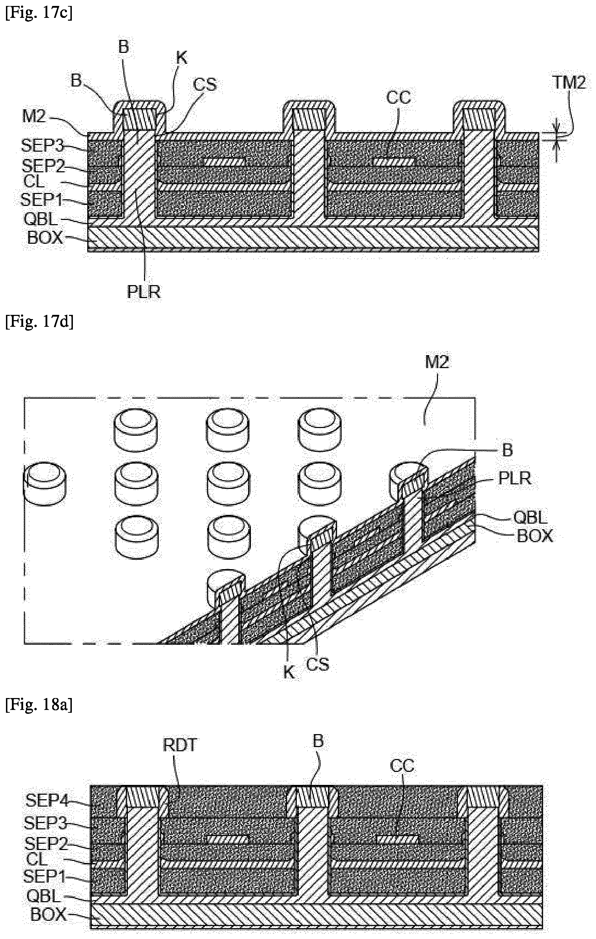

La formation PROC301 des lignes de lecture RDT peut comprendre dans un premier temps le dépôt d'une deuxième couche conductrice M2 sur la surface de contact CS de chaque pilier PLR, sur chaque plot de protection B et sur la troisième couche de séparation SEP3, tel qu'illustré par les [FIG. 17c] et [FIG. 17d]. La deuxième couche conductrice M2 présente une épaisseur TM2 pouvant être comprise entre 10 nm et 15 nm. La deuxième couche conductrice M2 peut être réalisée à partir de silicium polycristallin dopé. Son dépôt peut être précédé d'une épitaxie de silicium dopé au phosphore Si:P ou de silicium et germanium dopé au bore SiGe:B. De cette manière, l'interface entre la surface de contact CS de chaque pilier et la deuxième couche conductrice M2 est améliorée.

La formation PROC301 des lignes de lecture RDT peut également comprendre la structuration de la deuxième couche conductrice M2 de manière à obtenir chaque ligne de lecture RDT telles qu'illustrées par les [FIG. 17a] et [FIG. 17b]. La structuration de la deuxième couche conductrice M2 peut être réalisée par photolithographie d'un masque de résine à travers lequel la deuxième couche conductrice M2 est gravée. La structuration est préférentiellement réalisée de manière à former des lignes de lecture RDT sensiblement parallèles les unes aux autres. Par sensiblement parallèle, on entend parallèle à ± 30° près, préférentiellement à ± 20°, voire à ± 10° près. Elle est également réalisée de manière à disposer deux lignes de lecture RDT de part et d'autre d'un pilier PLR, chacune des lignes étant au moins en contact avec la surface de contact CS dudit pilier PLR. Les lignes de lecture RDT illustrées par les [FIG. 17a] et [FIG. 17b] comprennent également une pluralité de portions transversales RDTT recouvrant entièrement les plots de protection B et les surface de contact CS des piliers PLR. Les portions transversales RDTT apparaissent lorsque le masque en résine photolithographié comporte des portions au-dessus de chaque pilier PLR, protégeant ces dernier pendant la gravure et évitant de retirer la deuxième couche conductrice M2 des flancs K des plots de protection B et des surfaces de contact CS.

La structuration de la deuxième couche conductrice M2 peut également être réalisée de manière auto-alignée, sans nécessiter de portions transversales RDTT. La gravure de la deuxième couche conductrice M2 est par exemple réalisée de manière anisotrope à travers un masque en résine photolithographié ne comprenant pas de portions au-dessus de chaque pilier PLR. La topologie de chaque pilier PLR a pour effet de former des espaceurs de deuxième couche conductrice M2 autour de chaque piller PLR.

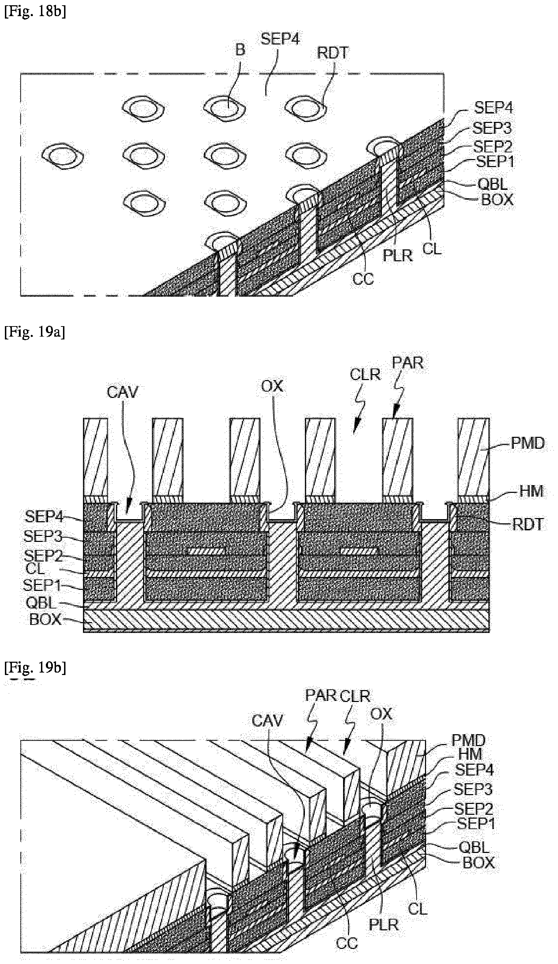

Les [FIG. 18a] et [FIG. 18b] illustrent les étapes de dépôt PROC302 de la quatrième couche de séparation SEP4 et d'aplanissement PROC303 de la quatrième couche de séparation SEP4. Le dépôt PROC302 de la quatrième couche de séparation SEP4 est réalisée de manière à recouvrir toute la structure, notamment les lignes de lectures RDT et préférentiellement la troisième couche de séparation SEP3 et les plots de protection B lorsque ceux-ci ne sont pas recouverts par des lignes de lecture RDT. La quatrième couche de séparation SEP4 peut être réalisée à partir d'oxyde de silicium. La quatrième couche de séparation SEP4 est ensuite aplanie PROC303 jusqu'à libérer le sommet des plots de protection B. Lors de cette étape PROC303, une partie de chaque ligne de lecture RDT peut être retirée, notamment lorsque ces dernières recouvrent les plots de protection B. En procédant de la sorte, chaque plot de protection B débouche de la surface de la quatrième couche de séparation SEP4.

Les [FIG. 19a] et [FIG. 19b] illustrent la gravure PROC304 sélective des plots de protection B par rapport à la quatrième couche de séparation SEP4 et par rapport aux lignes de lecture RDT. La gravure PROC304 peut être réalisée de manière isotrope. Elle est préférentiellement arrêtée sur le sommet de chaque pilier PLR, laissant apparaître le matériau semiconducteur de chaque pilier PLR. La gravure PROC304 des plots de protection B permet ainsi de former une pluralité de cavités CAV à l'aplomb de chaque pilier PLR. Chaque cavité CAV est préférentiellement entourée d'une ligne de lecture RDT.

Chaque cavité CAV est destinée à accueillir une grille de chargement CHAR permettant de former, avec un pilier PLR et une ligne de lecture RDT, un transistor à électron unique. Les [FIG. 19a] et [FIG. 19b] illustrent une première étape de la formation PROC305 de la grille de chargement CHAR, dans chaque cavité CAV. En premier lieu, les parois de chaque cavité CAV, et préférentiellement les parties apparentes des lignes de lecture RDT, sont oxydées de manière à former une septième couche diélectrique OX, dite "oxyde de grille". L'oxyde de grille OX est préférentiellement formé par oxydation thermique et présente avantageusement une épaisseur comprise entre 2 nm et 5 nm.

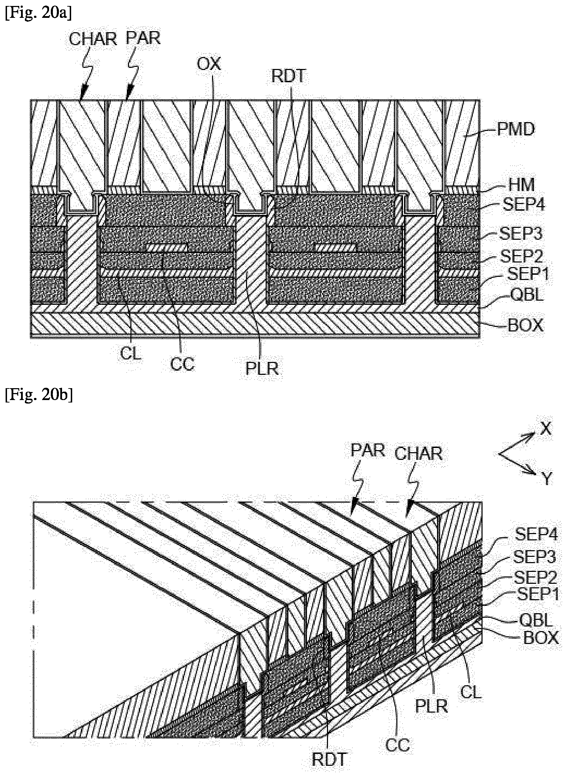

La formation PROC305 de la grille de chargement CHAR comprend également le remplissage de chaque cavité CAV, tel qu'illustré par les [FIG. 20a] et [FIG. 20b], avec un matériau conducteur tel qu'un métal ou un ensemble de couches métalliques. Le remplissage de chaque cavité CAV comprend par exemple un dépôt conforme d'une première couche métallique, par exemple de titane Ti, de manière à recouvrir l'oxyde de grille OX au fond de chaque cavité CAV. Le remplissage des cavités CAV peut également comprendre le dépôt conforme d'une couche de siliciure, par exemple en nitrure de titane TiN, de manière à recouvrir la première couche métallique. Enfin, le remplissage peut comprendre le dépôt d'une deuxième couche métallique, par exemple en tungstène W, recouvrant la couche de siliciure et remplissant totalement chaque cavité CAV.

Les grilles de chargement CHAR peuvent être structurées de manière à connecter une pluralité de transistors à électron unique. Elles sont avantageusement sensiblement parallèles les unes aux autres et orientées selon l'une des première ou deuxième direction X, Y. De la sorte, les grilles de chargement CHAR peuvent contrôler une pluralité de piliers PLR. Toutefois, afin de réduire le couplage capacitif entre les lignes de lecture RDT et les grilles de chargement CHAR, ces dernières sont avantageusement orientées perpendiculairement aux lignes de lecture RDT.

Ainsi, après l'étape d'aplanissement PROC303 de la quatrième couche de séparation SEP4 et avant l'étape de gravure PROC304 des plots de protection B de manière à former les cavités CAV, le procédé PROC peut comprendre une étape de formation PROC306 de couloirs CLR, chaque couloir CLR étant préférentiellement aligné avec une pluralité de piliers PLR. Les grilles de chargement CHAR sont alors préférentiellement formées dans chaque couloir CLR. Les grilles de chargement CHAR sont ainsi isolées deux à deux. Les couloirs CLR sont séparés deux à deux par une paroi PAR.

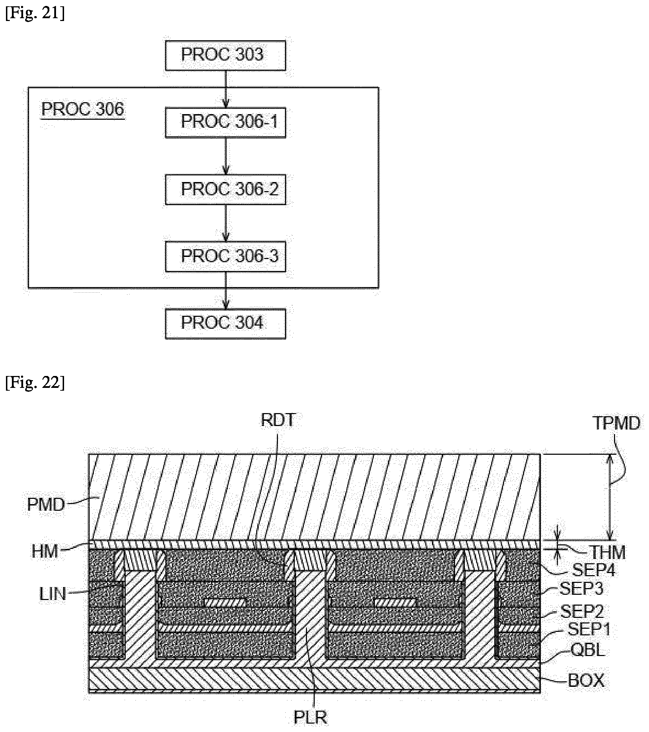

L'étape de formation PROC306 des couloirs CLR, schématisée par la [FIG. 21]. Elle comprend une première sous-étape PROC306-1, illustrée par la [FIG.22], comprenant le dépôt d'un masque dur HM recouvrant la quatrième couche de séparation SEP4, les lignes de lecture RDT et les plots de protection B. La couche de masque dur peut être réalisée à partir de nitrure de silicium SiN ou de nitrure de titane TiN. Elle présente préférentiellement une épaisseur THM comprise entre 10 nm et 30 nm.

L'étape de formation PROC306 des couloirs CLR comprend une deuxième sous-étape PROC306-2, également illustrée par la [FIG. 22], comprenant le dépôt d'une couche d'encapsulation PMD recouvrant le masque dur HM. La couche d'encapsulation PMD est préférentiellement réalisée à partir d'oxyde de silicium SiO₂ et peut présenter une épaisseur TPMD supérieure à 80 nm.

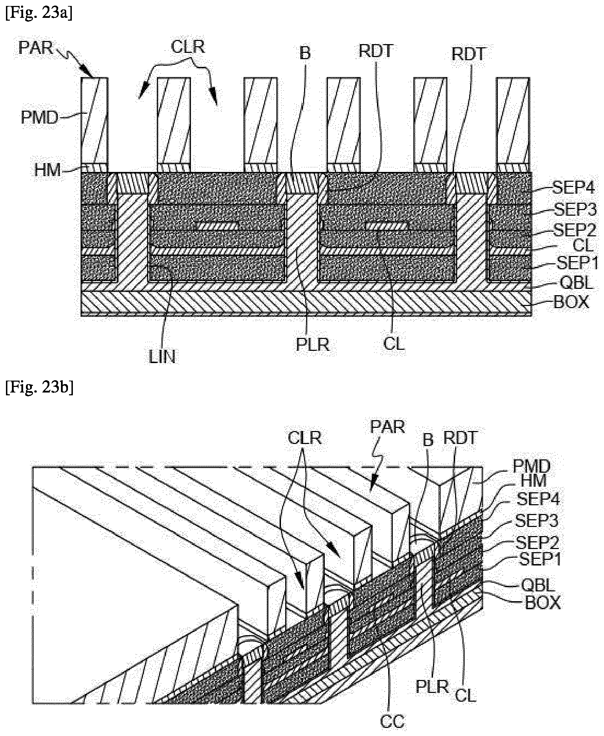

Les couches d'encapsulation PMD et de masque dur HM sont ensuite gravées lors d'une troisième sous-étape PROC306-3, illustrée par les [FIG. 23a] et [FIG. 23b], de manière à former des tranchées dans les matériaux précités, formant les couloirs CLR. La gravure PROC306-3 est préférentiellement réalisée à travers un masque de résine obtenu par une étape de photolithographie. La gravure des couches d'encapsulation PMD et de masque dur HM s'arrête au niveau du sommet des plots de protection B. Les parois PAR séparant les couloirs comprennent alors avantageusement une portion de masque dur HM et une portion de couche d'encapsulation PMD.

L'étape de gravure PROC304 des plots de protection B, illustrée par le [FIG. 19a] et [FIG. 19b], est avantageusement réalisée lorsque les parois PAR séparant les couloirs sont déjà en place. De la sorte, l'étape de formation PROC306 des grilles de chargement CHAR, illustrées par les [FIG. 20a] et [FIG. 20b] permet d'obtenir des grilles CHAR structurées et isolées les unes des autres.

La formation PROC306 des grilles de chargement CHAR peut alors comprendre le dépôt conforme de la couche métallique dans chaque cavité CAV et dans chaque couloire CLR. Il en est de même pour le dépôt conforme de la couche de siliciure. Le remplissage de chaque cavité CAV peut également permettre de remplir chaque couloir CLR. À l'issue de l'étape de formation PROC306 des grilles de chargement CHAR, un aplanissement peut être réalisé de manière à garantir l'absence de court-circuit entre les grilles de chargement.

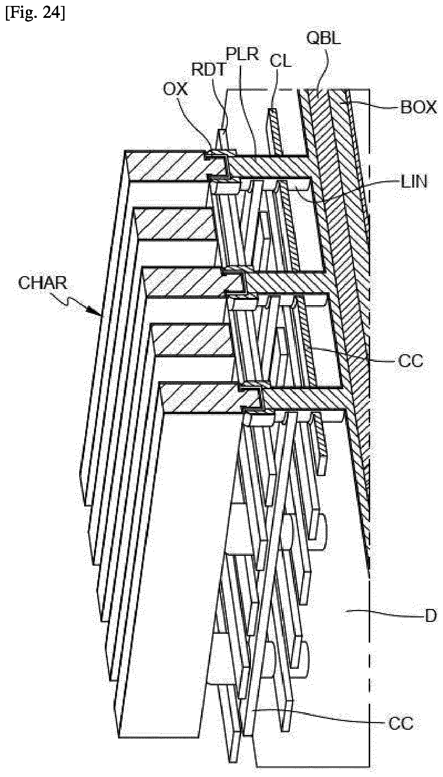

La [FIG. 24] présente schématiquement le circuit DISP électronique quantique susceptible d'être obtenu à l'issue du procédé de fabrication selon le troisième mode de mise en œuvre. Les première, deuxième, troisième et quatrième couches de séparation SPE1, SEP2, SEP3, SEP4 sont masquées afin de présenter, par rapport à chaque pilier PLR et à la couche qubit QBL, la superposition des lignes de couplage CL, des colonnes de couplages CC, des lignes de lecture RDT et des grilles de chargement CHAR.

Le mode de réalisation du circuit DISP de la [FIG. 24] diffère ainsi du mode de réalisation des [FIG. 11a] et [FIG. 11b] en ce que le circuit DISP comprend :
- une pluralité de lignes de lecture RDT s'étendant sur la troisième couche de séparation SEP3, chaque ligne de lecture RDT étant en contact avec au moins pilier semiconducteur PLR ; et
- une pluralité de grille de chargement CHAR, chaque grille de chargement formant, avec une ligne de lecture RDT et un pilier semiconducteur PLR, un transistor à électron unique.

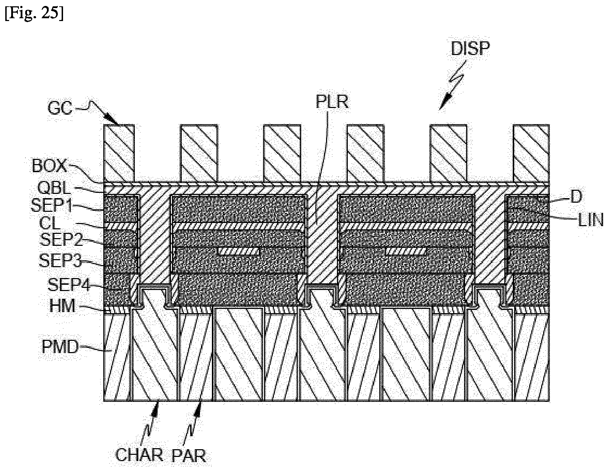

La [FIG. 25] présente schématiquement le circuit DISP obtenu lors d'un développement du procédé PROC. Une pluralité de grille de contrôle GC peut être ajoutée au circuit précédemment obtenu de manière à contrôler et manipuler l'état de chaque qubit. Pour cela, le circuit DISP est retourné. Lorsque le circuit DISP est réalisé à partir d'un substrat de type SOI, c'est à dire comprenant une couche isolante BOX enterrée sous la couche qubit QBL, alors il est gravé jusqu'à atteindre la couche isolante BOX. Ensuite, une pluralité de grilles de contrôle GC, réalisées dans une matériau conducteur, est formée sur la couche isolante BOX. Les grilles de contrôle GC sont préférentiellement sensiblement parallèles entre elles et sont disposées entre chaque pilier PLR.

Alternativement, la couche isolante BOX peut être amincie. Elle peut également être complètement retirée et de manière à déposer une nouvelle couche d'oxyde, par exemple plus mince que la couche isolante BOX, sur la couche qubit QBL. La pluralité de grilles de contrôle GC est ensuite formée sur la nouvelle couche d'oxyde.

## Revendications

1. Procédé (PROC) de fabrication d'un circuit électronique quantique, le procédé étant mis en œuvre à partir d'un substrat (SUB) comportant sur l'une de ses surfaces une première couche semiconductrice (S1) monocristalline et comprenant les étapes suivantes :
- graver (PROC102) la première couche semiconductrice (S1) de manière à :
- obtenir une pluralité de piliers semiconducteurs (PLR), chaque pilier semiconducteur (PLR) présentant une première extrémité (PLRa), dite "base" ; et
- conserver une partie (QBL) de la première couche semiconductrice (S1) dite "couche qubits", à la base (PLRa) de chaque pilier semiconducteur (PLR) ;
- oxyder (PROC103) le flanc de chaque pilier semiconducteur (PLR) de manière à former une pluralité de premières couches diélectriques (LIN), dites "diélectriques de flanc" ;
- déposer (PROC104) une deuxième couche diélectrique (SEP1), dite "première couche de séparation", sur la couche qubits (QBL) ;
- former (PROC105) une pluralité de premières électrodes (CL) conductrices sensiblement parallèles entre elles, dites "lignes de couplage", sur la première couche de séparation (SEP1), chaque ligne de couplage étant en contact avec le diélectrique de flanc (LIN) d'au moins un pilier semiconducteur (PLR) ;
- déposer (PROC106) une troisième couche diélectrique (SEP2), dite "deuxième couche de séparation", sur la pluralité de lignes de couplage (CL) ;
- former (PROC107) une pluralité de deuxièmes électrodes (CC) conductrices sensiblement parallèles entre elles, dites "colonnes de couplage", sur la deuxième couche de séparation (SEP2), chaque colonne de couplage étant en contact avec le diélectrique de flanc (LIN) d'au moins un pilier semiconducteur (PLR) ;
- déposer (PROC108) une quatrième couche diélectrique (SEP3), dite "troisième couche de séparation", sur la pluralité de colonnes (CC) de sorte qu'une portion de chaque diélectrique de flanc (LIN) dépasse de la troisième couche de séparation (SEP3) ; et
- graver (PROC109) chaque portion des diélectriques de flanc (LIN) dépassant de la troisième couche de séparation (SEP3) afin d'exposer une surface (CS) de chaque pilier semiconducteur (PLR), dite "surface de contact".

2. Procédé (PROC) selon la revendication précédente, dans lequel l'épaisseur (TQBL) de la couche qubits (QBL) est comprise entre 5 nm et 35 nm.

3. Procédé (PROC) selon l'une des revendications précédentes, dans lequel les lignes de couplage (CL) croisent les colonnes de couplages (CC).

4. Procédé (PROC) selon l'une des revendications précédentes, dans lequel la première couche semiconductrice (S1) est en silicium enrichi par un isotope.

5. Procédé (PROC) selon l'une des revendications précédentes, dans lequel la première couche semiconductrice (S1) comprend une couche semiconductrice monocristalline en face avant (FRT) et une couche semiconductrice monocristalline épitaxiée (EPI), la couche semiconductrice monocristalline épitaxiée (EPI) étant obtenue au moyen d'une épitaxie pleine plaque à partir de la couche semiconductrice monocristalline en face avant (FRT).

6. Procédé (PROC) selon l'une des revendications précédentes, dans lequel l'étape d'oxydation (PROC103) permettant de former le diélectrique de flanc (LIN) pour chaque pilier semiconducteur (PLR) comprend les sous-étapes suivantes :
- oxyder (PROC103-1) la surface libre de chaque pilier semiconducteur (PLR) de sorte à former, au niveau du flanc de chaque pilier semiconducteur (PLR), une couche diélectrique sacrificielle ;
- retirer (PROC103-2) la couche diélectrique sacrificielle ; et
- oxyder (PROC103-3) la surface libre de chaque pilier semiconducteur (PLR) de sorte à former, au niveau du flanc de chaque pilier semiconducteur (PLR), le diélectrique de flanc (LIN).

7. Procédé (PROC) selon l'une des revendications précédentes, dans lequel chaque diélectrique de flanc (LIN) est obtenu par oxydation thermique du flanc de chaque pilier semiconducteur (PLR).

8. Procédé (PROC) selon l'une des revendications précédentes, dans lequel la formation (PROC105) de la pluralité de lignes de couplage (CL) comprend :
- déposer (PROC105-1) de manière conforme d'une première couche conductrice (M1) recouvrant intégralement la première couche de séparation (SEP1) et chaque pilier semiconducteur (PLR) ;
- déposer (PROC105-2) une cinquième couche de diélectrique (D3) de manière à recouvrir complètement la première couche conductrice (M1) ;
- graver (PROC105-3) la cinquième couche de diélectrique (D3) de manière à mettre à nu une pluralité de portions CAP de la première couche conductrice (M1), dites "capuchons", et conserver une épaisseur résiduelle (TD3) de la cinquième couche de diélectrique (D3), chaque capuchon (CAP) recouvrant une portion supérieure de chaque pilier semiconducteur (PLR) ;
- graver (PROC105-4) la première couche conductrice (M1) et la cinquième couche diélectrique (D3) de manière à retirer chaque capuchon (CAP) et l'épaisseur résiduelle (TD3) de la cinquième couche diélectrique (D3) ;
- graver (PROC105-6) la première couche conductrice (M1) de manière à obtenir les lignes de couplage (CL).

9. Procédé (PROC) selon l'une des revendications précédentes, comprenant, avant la gravure (PROC102) de la première couche semiconductrice (S1), la formation (PROC101) d'une pluralité de plots de protection (B) sur la première couche semiconductrice (S1), la gravure (PROC102) de la première couche semiconductrice (S1) comprenant une gravure anisotrope d'une première partie (G) de la première couche semiconductrice (S1) de manière à obtenir un pilier semiconducteur (PLR) sous chaque plot sacrificiel (B).

10. Procédé (PROC) selon la revendication 8, comprenant, après la gravure (PROC109) de chaque portion des diélectriques de flanc (LIN), les étapes supplémentaires suivantes :
- retirer (PROC201) le plot de protection (B) de chaque pilier semiconducteur (PLR) de manière à exposer la tête (PLRb) dudit pilier semiconducteur (PLR) ; et
- déposer (PROC202) une couche conductrice dopée, dite "couche d'initialisation", recouvrant au moins la deuxième extrémité (PLRb) et la surface de contact (CS) de chaque pilier semiconducteur (PLR).

11. Procédé (PROC) selon la revendication précédente, dans lequel la couche d'initialisation (INI) est en silicium polycristallin fortement dopé.

12. Procédé (PROC) selon la revendication 8, comprenant, après la gravure (PROC109) de chaque portion des diélectriques de flanc (LIN), les étapes supplémentaires suivantes :
- former (PROC301) une pluralité de troisièmes électrodes (RDT) conductrices dopées, dites "lignes de lecture", chaque ligne de lecture (RDT) étant en contact avec au moins un pilier semiconducteur (PLR) ;
- déposer (PROC302) une sixième couche diélectrique (SEP4), dite "quatrième couche de séparation", recouvrant les lignes de lecture (RDT) et recouvrant la pluralité de plots de protection (B) ;
- aplanir (PROC303) la quatrième couche de séparation (SEP4) et la pluralité de lignes de lecture (RDT) jusqu'à atteindre les plots de protection (B) ;
- graver (PROC304) sélectivement la pluralité de plots de protection (B) de manière à laisser une pluralité de cavités à l'aplomb de chaque pilier semiconducteur (PLR) ; et
- former (PROC305) une structure de grille, "dite grille de chargement", dans chaque cavité.

13. Procédé (PROC) selon la revendication précédente dans lequel chaque ligne de lecture (RDT) est en contact avec la surface de contact (CS) d'au moins un pilier semiconducteur (PLR).

14. Circuit (DISP) électronique quantique susceptible d'être obtenu par la mise en œuvre du procédé (PROC) de fabrication selon l'une quelconque des revendications précédentes.
